Europäisches Patentamt

European Patent Office

Office européen des brevets

(11) Veröffentlichungsnummer: **0 204 169**

**A1**

# (12) EUROPÄISCHE PATENTANMELDUNG

(21) Anmeldenummer: 86106227.1

(22) Anmeldetag: 06.05.86

(51) Int. Cl.4: **H01J 37/30** , G03F 1/00 , C03C 10/00

(30) Priorität: 06.05.85 DE 3516215

(43) Veröffentlichungstag der Anmeldung:
10.12.86 Patentblatt 86/50

(84) Benannte Vertragsstaaten:
AT BE CH DE FR GB IT LI LU NL SE

(71) Anmelder: **Siemens Aktiengesellschaft Berlin und München**
**Wittelsbacherplatz 2**
**D-8000 München 2(DE)**

(72) Erfinder: **Baute, Manfred**
**Böhmerwaldstrasse 58**
**D-8017 Ebersberg(DE)**

(54) Trägermaterial für Elektronenstrahlanlagen.

(57) Trägermaterialien für Elektronenstrahlanlagen zur Halbleiterfertigung dürfen höchstens mininalen Temperatureinflüssen unterliegen, da sie wesentliche Auswirkungen auf die Einstellgenauigkeit besitzen. Die Verwendung einer Glaskeramik mit einer kristallinen Phase mit Hochquarzstruktur und einer Restglasphase erlaubt eine weitgehende Kompensation der thermischen Ausdehnung beider Phasen. Der Einsatz der Glaskeramik für Maskensubstrat, Maskenkassetten, Aufnahmetisch mit Trägerarm und Spiegelsubstrat verringert sowohl den Zeitaufwand als auch die Fehlerbelastung bei der Temperaturkontrolle der Anlage.

EP 0 204 169 A1

## Trägermaterial für Elektronenstrahlanlagen

Die vorliegende Erfindung betrifft die Verwendung einer Glaskeramik nach dem Oberbegriff des Patentanspruchs 1.

Die Maßhaltigkeit verwendeter Materialien in Elektronenstrahlanlagen bestimmt wesentlich die Genauigkeit und Reproduzierbarkeit der mit Hilfe dieser Anlagen zu bearbeitenden oder herzustellenden Produkte. So versucht man, temperaturbedingte Dehnungen der Materialien durch eine hochpräzise Temperaturregelung zu vermeiden. Da jedoch Elektronenstrahlanlagen unter Vakuumbedingungen arbeiten ist die Erfassung und Verarbeitung möglichst vieler Meßwerte schwierig. Weiterhin können die material-und volumenabhängigen Temperaturkapazitäten nur schwer berücksichtigt werden. Bislang wurden die Temperaturen deshalb im Rahmen des Möglichen kontrolliert und eventuelle Dehnungen entsprechend hochgerechnet.

Diese Vorgehensweise ist sehr zeitaufwendig und aufgrund hoher Meßtoleranzen der Temperaturmeßsysteme zudem stark fehlerbelastet.

Der Erfindung liegt die Aufgabe zugrunde, eine Möglichkeit zur Reduzierung von Temperatureinflüssen auf Elektronenstrahlanlagen anzugeben.

Diese Aufgabe wird erfindungsgemäß durch die Verwendung eines Materials der eingangs genannten Art durch die Merkmale des kennzeichnenden Teils des Patentanspruchs 1 gelöst.

Ausgestaltungen des Erfindungsgedankens sind in Unteransprüchen gekennzeichnet.

Der Erfindung liegt der Gedanke zugrunde, möglichst alle Teile, die aufgrund von Temperaturschwankungen Einfluß auf die Genauigkeit und Reproduzierbarkeit von Elektronenstrahlanlagen nehmen, durch ein Material mit möglichst geringer Wärmedehnung zu ersetzen. Dafür kommen im wewesentlichen die Trägermaterialien wie das Substrat für Elektronenstrahlmasken, die Substratträger für die Masken, der Aufnahmetisch mit seinem Trägerarm sowie die Substrate für die Justierspiegel des Aufnahmetisches in Frage. An ein derartiges Trägermaterial müssen dabei bezüglich des mechanischen und thermischen Verhaltens hohe Anforderungen gestellt werden, die erfindungsgemäß eine Glaskeramik erfüllt.

Eine Glaskeramik ist ein anorganischer Werkstoff, der neben glasartigen Bestandteilen auch kristalline Phasen enthält. Mögliche Eigenschaften einer Glaskeramik gehen aus einem Prospekt über eine unter dem Warenzeichen ZERODUR eingetragene Glaskeramik der Firma Schott & Gen., Mainz, hervor. So sind entsprechend hergestellte Glaskeramiken homogen im Volumen und sowohl hinsichtlich ihrer mechanischen und thermischen Eigenschaften. Sie lassen sich sägen, bohren, fräsen sowie schleifen und, ähnlich wie optisch oder technische Gläser, polieren.

Die geringe Temperaturabhängigkeit einer erfindungsgemäß zu verwendenden Glaskeramik beruht darauf, daß die kristalline Phase eine negative, die Glasphase dagegen eine positive thermische Ausdehnung aufweist. Die lineare thermische Ausdehnung der Glaskeramik insgesamt wird dadurch weitgehend kompensiert. Erfindungsgemäß wird eine Glaskeramik mit 70 -75 Prozenten kristalliner Phase mit Hochquarzstruktur, die eine mittlere Kristallitgröße von 50 nm besitzt und, mit einer Restglasphase von 25 -30 Gewichtsprozenten verwendet.. Der mittlere lineare Ausdehnungskoeffizient einer derartigen Glaskeramik liegt im Temperaturbereich von -160 bis +20 °C unter $1,8 \times 10^{-7}/K$, im Temperaturbereich von +20 bis +300 °C unter $2,2 \times 10^{-7}/K$ und im Temperaturbereich von +300 bis +600 °C unter $3,8 \times 10^{-7}/K$. Im Temperaturbereich von 0 bis +50°C beträgt der mittlere lineare thermische Ausdehnungskoeffizient sogar nur $\pm 1 \bullet 10^{-7}/K$, so daß bei einer normalen Betriebstemperatur von 20°C höchstens minimale Temperatureinflüsse auftreten.

Weitere physikalische, chemische und optische Eigenschaften einer erfindungsgemäß zu verwendenden Glaskeramik weisen mit Quarz oder Glas. vergleichbare oder bessere Kennzahlen auf. So liegt der Längenalterungskoeffizient unter $1 \times 10^{-7}/Jahr$, ein Bereich hoher Transparenz existiert für Wellenlängen unter 400 nm bis über 2600 nm und bei Normaltemperatur greift einzig Flußsäure die Glaskeramik an. Elektrisch zeigt die Glaskeramik einen hohen spezifischen Widerstand bei gleichzeitig niedrigem Verlustfaktor. Beschichtung und Ablösung von Metallen zur Verspiegelung ist problemlos möglich.

Die erfindungsgemäße Verwendung einer derartigen Glaskeramik als Trägermaterial in Elektronenstrahlanlagen wird nachfolgend anhand einiger Ausführungsbeispiele erläutert.

Im ersten Ausführungsbeispiel wird die Glaskeramik erfindungsgemäß als Substrat für Elektronenstrahlmasken eingesetzt. Die als Maskenträger dienende Glaskeramik wird mit einem Metall wie beispielsweise Chrom oder Schwarzchrom bedampft, mit einem elektronenstrahlempfindlichen Lack beschichtet und anschließend mit Hilfe an sich bekannter Verfahren strukturiert. Eine derartige Maske. dient insbesondere als Market-Maske, das heißt, als Eichnormal zur Justierung einer beziehungsweise zur Abstimmung mehrerer Elektronenstrahlanlagen. Aufgrund des außerordentlich niedrigen linearen thermischen Ausdehnungskoeffizienten der Glaskeramik, der weit innerhalb üblicher Spezifikationen für Elektronenstrahlmasken-Schreiber und der mit deren Hilfe hergestellten Halbleitermasken liegt, läßt sich die Justierungs-oder Abstimmungsprozedur einer derartigen Anlage wesentlich beschleunigen. Dies gilt insbesondere für die zeitraubenden Temperierungs-und anschließenden thermischen Beruhigungszeiten. Vergleichsweise liegen nämlich bei den bisher verwendeten Materialien Quarz bzw. Low-expansion-Glas die linearen thermischen Ausdehnungskoeffizienten um mindestens den Faktor 2,3 beziehungsweise 17 höher.

Aus der mit vorliegender Anmeldung eingereichten Anmeldung 85 E 1381 DE geht hervor, die Eigenschaften und Lebensdauer einer derartigen als Eichnormal dienenden Elektronenstrahlmaske dadurch zu verbessern, daß beispielsweise das Glaskeramik-Substrat mit zwei Metallschichten unterschiedlicher Leitfähigkeit bedampft wird.

Dies kann beispielsweise eine Chromschicht, speziell 20 bis 90 nm dick, direkt auf dem Substrat und eine über ihr liegende Schicht aus Schwarzchrom, speziell 20 bis 30 nm dick, oder aber eine Goldschicht direkt auf dem Substrat mit vergleichbarer Dicke wie die Chromschicht mit einer die Goldschicht bedeckenden Schicht aus Chrom oder Schwarzchrom mit einer der Schwarzchromschicht des ersten Beispiels vergleichbaren Dicke sein. Auf beide Schichten wird ein elektronenstrahlempfindlicher Positivlack aufgetragen, der Lack und die unter ihm liegenden Metallschichten werden mit an sich bekannten Mitteln strukturiert und anschließend wir die Lackschicht wieder abgetragen.

Als zweites Ausführungsbeispiel einer erfindungsgemäßen Verwendung einer Glaskeramik lassen sich Substratträger, zum Beispiel für Elektronenstrahlmasken angeben, die wesentlich mitverantwortlich für Maßänderungen sind. Die Glaskeramik läßt sich so zum Beispiel für Maskenkassetten verwenden, indem sie zur Aufnahme zum Beispiel einer Elektronenstrahlmaske mechanisch bearbeitet und metallisiert wird. Trotz der Ausstattung einer derartigen Kassette unter anderem mit Führungspunkten und Halte-bzw. Ableitklemmen ergibt sich gegenüber dem bisher vielfach verwendeten Aluminium ein wesentlich geringerer Temperatureinfluß auf die Dehnungseigenschaften.

Weitere Ausführungsbeispiele einer erfindungsgemäßen Verwendung von Glaskeramik betreffen "stages", das heißt, den Aufnahmetisch eines Elektronenstrahlschreibers inklusive polierte Spiegel für die laserinterferometrische Messung der Tischposition des Elektronenstrahlschreibers. Der Aufnahmetisch und das Substrat für die Spiegel werden dabei nach mechanischer Bearbeitung mit Metal bedampft, wobei die auf dem Spiegelsubstrat aufgedampfte Metallschicht poliert wird und so als Spiegel dient. Als weiteres Ausführungsbeispiel können auch paddle-arms, das heißt, die Trägerarme für stages dienen, für die ebenfalls Glaskeramik verwendet wird, die nach mechanischer Bearbeitung mit Metall bedampft wird. Als Trägermaterial für stages und paddle-arms kam bisher alternativ Beryllium in Frage, das allerdings wesentlich schlechtere Temperatureigenschaften besitzt.

Die erfindungsgemäße Verwendung von Glaskeramik als Trägermaterial für stages, Spiegelsubstrat und paddlearms verbessert die bisher stark fehlerbehaftete und zeitaufwendige Prozedur der Kontrolle und anschließenden Hochrechnung eventueller Dehnungen, die durch hohe Meßtoleranzen der Temperaturmeßsysteme zusätzlich negativ beeinflußt wurde. Mit der erfindungsgemäßen Verwendung von Glaskeramik als Trägermaterial in Elektronenstrahlanlagen kann dagegen der Einfluß der Temperatur weitgehend vernachlässigt werden.

**Ansprüche**

1. Glaskeramik mit 70 bis 75 Gewichtsprozenten kristalliner Phase mit Hochquarzstruktur, die eine mittlere Kristallitgröße von 50 nm besitzt und einer Restglasphase von 25 -30 Gewichtsprozenten, mit einem mittleren linearen Ausdehnungskoeffizienten unter $1,8 \times 10^{-7}$/K im Temperaturbereich von -160 bis +20 °C unter $2,2 \times 10^{-7}$/K Temperaturbereich von +20 bis +300 °C , und unter $1 \bullet 10^{-7}$/K im Temperaturbereich von 0 bis 50°C **gekennzeichnet durch** Verwendung als Trägermaterial in Elektronenstrahlanlagen.

2. Glaskeramik nach Anspruch 1, **gekennzeichnet durch** Verwendung als Substrat für Elektronenstrahlmasken.

3. Glaskeramik nach Anspruch 1, **gekennzeichnet durch** Verwendung als Substratträger für Elektronenstrahlmasken.

4. Glaskeramik nach Anspruch 1, **gekennzeichnet durch** Verwendung für einen Aufnahmetisch eines Elektronenstrahlschreibers.

5. Glaskeramik nach Anspruch 4, **gekennzeichnet durch** Verwendung als Substrat für am Aufnahmetisch eines Elektronenstrahlschreibers angebrachte Spiegel zur laserinterferometrischen Kontrolle der Tischposition.

6. Glaskeramik nach Anspruch 4 oder 5, **gekennzeichnet durch** Verwendung für einen Trägerarm eines Aufnahmetisches eines Elektronenstrahlschreibers.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-3 151 228 (SIEMENS) * Seite 6, Zeile 11 - Seite 7, Zeile 14; Seite 8, Zeile 17 - Seite 10, Zeile 25 * | 1,5 | H 01 J 37/30 G 03 F 1/00 C 03 C 10/00 |
| | --- | | |
| A | US-A-3 834 981 (GROSSMANN) * Insgesamt * | 1 | |
| | --- | | |
| A | PATENTS ABSTRACTS OF JAPAN, Band 17, Nr. 99 (E-172) [1244], 27. April 1983, Seite 67 E 172; & JP - A - 58 21 327 (TOKYO SHIBAURA DENKI K.K.) 08-02-1983 | | |
| | --- | | |
| A | PATENTS ABSTRACTS OF JAPAN, Band 9, Nr. 159, 4. Juli 1985, Seite 87 E 326; & JP - A - 60 37 729 (NIPPON DENSHIN DENWA KOSHA) 27-02-1985 | | RECHERCHIERTE SACHGEBIETE (Int. Cl.4) |
| | ----- | | G 03 F 1 C 03 C 10 H 01 J 37 |

Der vorliegende Recherchenbericht wurde für alle Patentansprüche erstellt.

| Recherchenort DEN HAAG | Abschlußdatum der Recherche 14-08-1986 | Prüfer SCHAUB G.G. |
|---|---|---|